# EUROPEAN PATENT APPLICATION

(11) **EP 4 707 054 A1**
(43) Date of publication of application: **11.03.2026**
(21) Application number: 24883608.2
(22) Date of filing: 27.11.2024
(51) Int. Cl.: B60L 53/302, B60L 53/31, B60L 53/53, B60L 53/16

(54) **ENERGY STORAGE DEVICE**

(30) Priority: 19.07.2024 CN 202421713576 U
(71) Applicant: Contemporary Amperex Technology Co., Ltd., Ningde, Fujian 352100 (CN); Contemporary Amperex Future Energy Technology (Shenzhen) Limited, Shenzhen, Guangdong 518100 (CN)
(72) Inventor: YANG, Le, Ningde, Fujian 352100 (CN); WU, Kai, Ningde, Fujian 352100 (CN); YU, Dongxu, Ningde, Fujian 352100 (CN); LI, Qing, Ningde, Fujian 352100 (CN); XING, Yanqing, Ningde, Fujian 352100 (CN); HAO, Xiaoxiao, Ningde, Fujian 352100 (CN)
(74) Representative: Ziebig Hengelhaupt Intellectual Property Attorneys Patentanwaltskanzlei PartGmbB
(86) International application number: PCT/CN2024/135018
(87) International publication number: WO 2026/016371

(57) **Abstract**

The present disclosure discloses an energy storage device, belonging to the technical field of batteries. The energy storage device comprises a cabinet, a battery pack, a charging converter, a charging connector, a cooling system and a first heat dissipation apparatus. The battery pack is installed inside the cabinet. The charging converter is electrically connected to the battery pack. The charging connector is electrically connected to the charging converter to transmit electric energy converted by the charging converter. The cooling flow channels of the charging connector and the cooling flow channels of the charging converter are arranged in the cooling system. The first heat dissipation apparatus is at least partially arranged in the cooling system to cool the charging connector and the charging converter. The cooling flow channels of the charging converter and the cooling flow channels of the charging connector in the embodiments of the present disclosure are both arranged in the cooling system, and the first heat dissipation apparatus is cooled by a fan to cool the charging converter and the charging connector.

## Description

### CROSS-REFERENCE TO RELATED APPLICATIONS

The present disclosure is filed based on and claims priority to Chinese Patent Application No. 202421713576.8 filed on July 19, 2024 and entitled "ENERGY STORAGE DEVICE", which is incorporated herein by reference in its entirety.

### TECHNICAL FIELD

The present disclosure relates to the technical field of batteries, and in particular to an energy storage device.

### BACKGROUND

New energy batteries are increasingly applied in life and industry. For example, new energy vehicles equipped with the batteries have been widely used. In addition, the batteries are further increasingly applied in the field of energy storage. The battery pack is installed in the energy storage device to charge electrical devices such as new energy vehicle through a charging connector. The charging converter and charging connector in the energy storage device will generate heat, requiring a certain degree of cooling.

In the related art, it is difficult for a structure for cooling the charging converter and the charging connector to fully utilize the corresponding heat dissipation apparatus.

### SUMMARY OF THE INVENTION

In view of this, the embodiments of the present disclosure are intended to provide an energy storage device, aiming to fully utilize the structure for cooling the charging converter and the charging connector.

In order to achieve the above purpose, the technical solutions in the embodiments of the present disclosure are implemented as follows:
A first aspect of the embodiments of the present disclosure provides an energy storage device, comprising:
a cabinet;
a battery pack, installed inside the cabinet;
a charging converter, electrically connected to the battery pack and used for converting electric energy outputted from or inputted to the battery pack;
a charging connector, electrically connected to the charging converter to transmit electric energy converted by the charging converter;
a cooling system, used for heat exchange with the charging converter and the charging connector;
a first heat dissipation apparatus, arranged in the cooling system;
at least one fan, installed inside the cabinet and used to dissipate heat from the first heat dissipation apparatus.

In the solutions of the embodiments of the present disclosure, the cooling flow channels of the charging converter and the cooling flow channels of the charging connector are both arranged in the cooling system, so that the cooling flow channels of the charging converter and the cooling flow channels of the charging connector are in the same cooling system, the first heat dissipation apparatus corresponding to the cooling system is arranged in the first cooling system, and the first heat dissipation apparatus is cooled by a fan to cool the charging converter and the charging connector. In the process of charging the electrical device through the charging connector, since the cooling flow channels of the charging converter and the cooling flow channels of the charging connector are in the same cooling system, the first heat dissipation apparatus corresponding to the cooling system can be fully utilized to dissipate heat from both the charging converter and the charging connector. Furthermore, in actual application scenarios, the temperature requirements on the temperature regulation medium for the charging converter and the charging connector are slightly different but relatively close. Therefore, in the same cooling system, the first heat dissipation apparatus and the cooling system can well dissipate heat for the two relatively close temperature requirements on the temperature regulation medium.

In an embodiment, the energy storage device further comprises a first circulation pump, and the cooling system comprises:
a first circulation loop, wherein both the first circulation pump and the cooling flow channels of the charging converter are connected in series in the first circulation loop;
a cooling sub-system, wherein the cooling flow channels of the charging connector are arranged in the cooling sub-system, the cooling sub-system comprises a first pipeline, the first pipeline is connected in series with the first circulation pump, the first pipeline is connected in parallel with the cooling flow channels of the charging converter, and the first heat dissipation apparatus is arranged in at least one of the first circulation loop and the cooling sub-system to cool the charging connector and the charging converter.

In the solutions of the embodiments of the present disclosure, the energy storage device further comprises a first circulation pump, the cooling system comprises a first circulation loop and a cooling sub-system, the cooling sub-system comprises a first pipeline, the charging converter is arranged in the first circulation loop, and the first heat dissipation apparatus is arranged in at least one of the first circulation loop and the cooling sub-system. The charging converter and the charging connector are arranged on different pipelines, which can facilitate the arrangement of the cooling system. The arrangement of the first circulation loop and the cooling sub-system can not be restricted by the relative positions of the charging converter and the charging connector. As the arrangement of the first circulation loop and the cooling sub-system is completed, the first heat dissipation apparatus can cool the charging connector and the charging converter. Furthermore, since the cooling temperatures of the charging connector and the charging converter are different, the cooling sub-system and the first circulation loop can adjust the flow rates of different temperature regulation media respectively to meet different cooling requirements.

In an embodiment, the cooling sub-system further comprises:
a first heat exchanger, wherein one of the heat exchange flow channels of the first heat exchanger is arranged in the first pipeline;
a second circulation pump;
a second circulation loop, wherein the cooling flow channels of the charging connector, the second circulation pump and another heat exchange flow channel of the first heat exchanger are connected in series in the second circulation loop, the second circulation loop and the first pipeline are isolated from each other, and the first heat dissipation apparatus is arranged in at least one of the first circulation loop, the heat exchange flow channels of the first heat exchanger and the second circulation loop.

In the solutions of the embodiments of the present disclosure, one of the heat exchange flow channels of the first heat exchanger is arranged in the first pipeline, another heat exchange flow channel thereof is connected in series in the second circulation loop, and the first pipeline and the second circulation loop are isolated from each other. The first circulation loop and the second circulation loop can be provided with different temperature regulation media according to the characteristics of the charging converter and the charging connector respectively, thereby increasing the adaptability of the energy storage device and providing a better user experience.

In an embodiment, the temperature regulation medium in the first circulation loop is water; and the temperature regulation medium in the second circulation loop is oil.

In the solutions of the embodiments of the present disclosure, the temperature regulation medium in the first circulation loop is water. The cooling capacity required by the charging converter is relatively high. The specific heat capacity of water is relatively large, and it can well cool the charging converter to well meet the cooling requirements of the charging converter. The temperature regulation medium in the second circulation loop is oil, which is difficult to conduct electricity. The energy storage device needs to discharge through the charging connector. In the process of cooling the charging connector, the risk of electric shock or short circuit caused by leakage of the temperature regulation medium is alleviated, and the energy storage device is safer.

In an embodiment, the cooling flow channels of the first heat dissipation apparatus are arranged in the first circulation loop, and both the first pipeline and the cooling flow channels of the charging converter are connected in series with the corresponding cooling flow channels of the first heat dissipation apparatus.

In the solutions of the embodiments of the present disclosure, both the first pipeline and the cooling flow channels of the charging converter are connected in series with the corresponding cooling flow channels of the first heat dissipation apparatus. In the process of cooling the charging connector, it is necessary to start the first circulation pump to make the temperature regulation medium flow in the first circulation loop, thereby providing power for cooling the charging converter. The first heat dissipation apparatus can cool the charging connector and the charging converter together.

In an embodiment, the first heat dissipation apparatus is a cooling container for accommodating a temperature regulation medium, a space in the cooling container for accommodating the temperature regulation medium is arranged in a cooling system, and a fan is used to drive air to flow through the first heat dissipation apparatus to dissipate heat from the first heat dissipation apparatus.

In the solutions of the embodiments of the present disclosure, the first heat dissipation apparatus is a cooling container for accommodating a temperature regulation medium, and the fan is used to blow air to the cooling container. In actual usage scenarios, the charging converter and the charging connector require the temperature of the temperature regulation medium to be higher than the ambient temperature, and the charging converter and the charging connector have a weaker demand for cooling capacity. The cooling requirements of the charging converter and the charging connector can be well met by a fan, and the manufacturing cost of the energy storage device is relatively low.

In an embodiment, the cooling container is located above the battery pack.

In the solutions of the embodiments of the present disclosure, the battery pack generates a large amount of heat during operation, and the battery pack has great heat dissipation requirements. The temperature regulation medium will bring the heat of the charging converter and the charging connector to the cooling container. Hot air usually floats upward. The cooling container located above the battery pack can alleviate the heat transfer from the cooling container to the battery pack, thereby capable of increasing the heat dissipation capacity of the battery pack to a certain extent.

In an embodiment, the cooling container is located above the fan.

In the solutions of the embodiments of the present disclosure, the cooling container is located above the fan, and the fan blows air upward. The generated wind acts on the cooling container, which can discharge the heat of the cooling container upward, resulting in a good heat dissipation effect. If the cooling container is placed below the fan and the fan blows air downward, the generated wind will carry the heat generated by the cooling container downward for a distance and then move upward, thereby acting on the cooling container again, resulting in a poor heat dissipation effect.

In an embodiment, the charging converter is a DC converter.

In the solutions of the embodiments of the present disclosure, the current parameters of the current output from the battery pack can be adjusted through the DC converter, thereby capable of adapting to the parameters of the input current of many electrical devices. The energy storage device has high adaptability.

In an embodiment, the charging converter is located inside the cabinet.

In the solutions of the embodiments of the present disclosure, the charging converter is located inside the cabinet, which can alleviate the influence of the external environment on the charging converter and makes it more convenient in the process of transferring the energy storage device.

### Invention Effects:

In the solutions of the embodiments of the present disclosure, the cooling flow channels of the charging converter and the cooling flow channels of the charging connector are both arranged in the cooling system, so that the cooling flow channels of the charging converter and the cooling flow channels of the charging connector are in the same cooling system, the first heat dissipation apparatus corresponding to the cooling system is arranged in the first cooling system, and the first heat dissipation apparatus is cooled by a fan to cool the charging converter and the charging connector. In the process of charging the electrical device through the charging connector, since the cooling flow channels of the charging converter and the cooling flow channels of the charging connector are in the same cooling system, the first heat dissipation apparatus corresponding to the cooling system can be fully utilized to dissipate heat from both the charging converter and the charging connector. Furthermore, in actual application scenarios, the temperature requirements on the temperature regulation medium for the charging converter and the charging connector are slightly different but relatively close. Therefore, in the same cooling system, the first heat dissipation apparatus and the cooling system can well dissipate heat for the two relatively close temperature requirements on the temperature regulation medium.

### BRIEF DESCRIPTION OF DRAWINGS

By reading the detailed description of the preferred implementations below, various other advantages and benefits will become apparent to those of ordinary skill in the art. The drawings are for the purpose of illustrating the preferred implementations only and are not to be considered a limitation to the present disclosure. Moreover, in all of the drawings, the same components are indicated by the same reference numerals. In the drawings:
FIG. 1 is a structural diagram of an energy storage device according to a first embodiment of the present disclosure;
FIG. 2 is a structural diagram of an energy storage device according to a second embodiment of the present disclosure;
FIG. 3 is a structural diagram of an energy storage device according to a third embodiment of the present disclosure;
FIG. 4 is a structural schematic diagram of an energy storage device according to a fourth embodiment of the present disclosure.

Description of Reference Numerals
1. Cabinet; 2. Battery pack; 3. Charging converter; 4. Charging connector; 5. Cooling system; 50. First circulation loop; 51. Cooling sub-system; 510. First pipeline; 511. Second circulation loop; 512. First heat exchanger; 513. Second circulation pump; 6. First heat dissipation apparatus; 60. Cooling container; 61. Fan; 7. First circulation pump; 8. Temperature regulation system; 800. Third circulation loop; 81. Second heat exchanger; 9. Second heat dissipation apparatus; 10. Third circulation pump.

### DETAILED DESCRIPTION

Examples of the technical solutions of the present disclosure will be described in detail below in conjunction with the drawings. The following embodiments are only used to illustrate the technical solutions of the present disclosure more clearly, and are therefore used only as examples, and should not be used to limit the protection scope of the present disclosure.

Unless otherwise defined, all technical and scientific terms used herein have the same meaning as commonly understood by those skilled in the art belonging to the technical field of the present disclosure; the terms used herein are intended only for the purpose of describing specific embodiments and are not intended to limit the present disclosure; the terms "including" and "having" and any variations thereof in the specification of the present disclosure and in the description of drawings above are intended to cover non-exclusive inclusion.

In the description of the embodiments of the present disclosure, the technical terms "first", "second", "third", and the like are used only to distinguish between different objects, and are not to be understood as indicating or implying a relative importance or implicitly specifying the number, particular order, or primary and secondary relation of the technical features indicated. In the description of the embodiments of the present disclosure, "a plurality of" means two or more, unless otherwise explicitly and specifically defined.

The reference to "embodiments" herein means that specific features, structures or characteristics described in combination with the embodiments may be included in at least one embodiment of the present disclosure. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described herein may be combined with other embodiments.

In the description of the embodiments of the present disclosure, the term "and/or" is only an association relationship for describing associated objects, indicating that three relationships may exist. For example, A and/or B may indicate three situations: A exists alone, both A and B exist, and B exists alone. In addition, the character "/" herein generally means that the associated objects before and after it are in an "or" relationship.

In the description of the embodiments of the present disclosure, the technical terms "top", "bottom", "upper", "lower", and the like indicate orientations or positional relationships based on the orientations or positional relationships shown in the drawings, and are intended only to facilitate and simplify the description of the embodiments of the present disclosure, and are not intended to indicate or imply that the apparatus or element referred to must have a particular orientation, or be constructed, operated, or used in a particular orientation, and therefore should not be construed as limitation of the embodiments of the present disclosure.

In the description of the embodiments of the present disclosure, unless otherwise explicitly specified and defined, the technical terms such as "mount", "link", "connect" and "fix" should be understood in a broad sense. For example, the connection may be fixed connection, detachable connection or integrated connection, may be mechanical connection or electrical connection, or may be direct connection, indirect connection through an intermediate, internal communication between two elements or interaction relationship between two elements. For those of ordinary skill in the art, the specific meanings of the above terms in the embodiments of the present disclosure can be understood according to specific situations.

In the description of the embodiments of the present disclosure, unless otherwise explicitly specified and defined, the technical term "contact" should be understood in a broad sense, which may be direct contact, or contact through an intermediate layer, or contact between two objects that have little or no interaction force, or contact between two objects that have interaction force.

In the related art, the battery pack of the energy storage apparatus supplies power to the charging connector through the charging converter, so that the charging connector can supply power to electrical devices such as electric vehicles, and the cooling flow channels of the charging converter and the cooling flow channels of the charging connector are respectively arranged in two independent cooling systems. The two independent cooling systems are thermally separated, that is, no corresponding heat exchanger is arranged between the two independent cooling systems, no heat exchanger is arranged across the two independent systems, and heat cannot be exchanged between the two independent cooling systems through the heat exchanger. In the process of charging through the charging connector, the charging converter and the charging connector need to be cooled respectively by the heat dissipation apparatuses corresponding to two independent cooling systems. It is difficult to fully utilize the heat dissipation apparatuses corresponding to one of the cooling systems to achieve the heat dissipation of the charging connector and the charging converter together.

In an embodiment of the present disclosure, the cooling for a charging converter 3 and a charging connector 4 is arranged in a cooling system 5, that is, the cooling flow channels of the charging converter 3 and the charging connector 4 are in the same cooling system, and the cooling system 5 and the corresponding first heat dissipation apparatus 6 cool the charging converter 3 and the charging connector 4. The charging converter 3 and the charging connector 4 are cooled by the first heat dissipation apparatus 6 corresponding to the cooling system 5. During the charging process, the first heat dissipation apparatus 6 corresponding to the cooling system 5 can be fully utilized to fully dissipate heat from the charging connector 4 and the charging converter 3.

A battery pack 2 refers to a device capable of outputting electric energy. Exemplarily, electric energy can be outputted through a battery pack 2 composed of battery cells. Exemplarily, electric energy can be output through a battery pack 2 composed of battery modules consisting of battery cells.

The present disclosure further provides a battery pack 2, wherein the battery pack 2 comprises a mounting shell and battery cells, wherein the battery cells are arranged inside the mounting shell.

In the embodiments of the present disclosure, the battery cell may be a secondary battery. The secondary battery refers to a battery cell that can be charged to activate the active material and continue to be used after the battery cell is discharged.

In the embodiments of the present disclosure, the battery cell may be a lithium-ion battery, a sodium ion battery, a sodium/lithium ion battery, a lithium metal battery, a sodium metal battery, a lithium sulfur battery, a magnesium-ion battery, a nickel hydrogen battery, a nickel cadmium battery, a lead storage battery, etc., which is not limited in the embodiments of the present disclosure.

Exemplarily, the battery cell includes a shell and an electrode assembly, and the electrode assembly is arranged in the shell.

In some embodiments, the shell may be a sealed structure or a non-sealed structure. As an example, when the shell is a non-sealed structure, the shell can protect the electrode assembly. A sealing bag is also included between the shell and the electrode assembly, and the sealing bag is used to encapsulate the electrode assembly and the electrolyte. Specifically, the sealing bag may be a bag-shaped insulating member or an aluminum-plastic film.

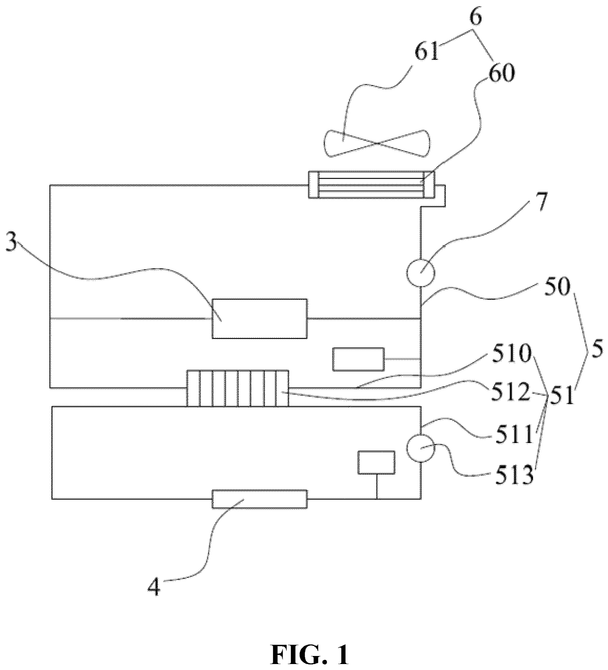

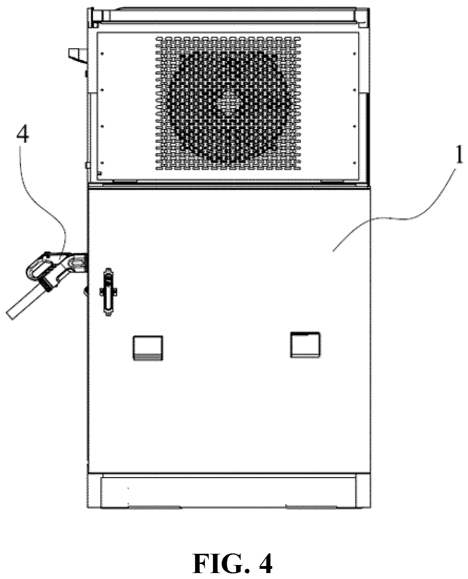

The present disclosure further provides an energy storage device. Referring to FIGS. 1 to 4, the energy storage device comprises a cabinet 1, a battery pack 2, a charging converter 3, a charging connector 4, a cooling system 5, a first heat dissipation apparatus 6 and at least one fan 61. The battery pack 2 is installed inside the cabinet 1. The charging converter 3 is electrically connected to the battery pack 2, and the charging converter 3 is used for converting electric energy outputted from or inputted to the battery pack 2. The charging connector 4 is electrically connected to the charging converter 3 to transmit electric energy converted by the charging converter 3. The cooling system 5 is used for heat exchange with the charging converter 3 and the charging connector 4. The first heat dissipation apparatus 6 is arranged in the cooling system 5. The fan 61 is installed in the cabinet 1 and the fan 61 is used to dissipate heat from the first heat dissipation apparatus 6.

Exemplarily, the cooling flow channels of the charging connector 4 and the cooling flow channels of the charging converter 3 are both arranged in the cooling system 5.

The charging converter 3 is a converter electrically connected between the battery pack 2 and the charging connector 4 for converting the electric energy outputted from or inputted to the battery pack 2.

A converter is an electrical apparatus that changes the voltage, frequency, number of phases and other electrical quantities or characteristics of a power supply system. The charging connector 4 is an electrical apparatus used to electrically connect to an electrical device so as to transfer the electrical energy in the battery pack 2 to the electrical device.

Exemplarily, the charging connector 4 is a charging gun.

Exemplarily, the charging connector 4 is a structure for charging new energy vehicles.

Exemplarily, the energy storage device is a new energy charging pile.

It should be noted that the cooling system 5 is a regulation system with a cooling function.

It should be noted that different regulation systems are thermally separated, that is, different regulation systems do not exchange heat through a heat exchanger, and no heat exchanger is installed across two different regulation systems.

It should be noted that, in the same regulation system, when the flow channels in the same system communicate with each other, the temperature regulation medium can circulate to the flow channels in the same regulation system; when there are flow channels isolated from each other in the same system, the flow channels isolated from each other are provided with a heat exchanger, and the heat exchanger is arranged across the flow channels isolated from each other, the temperature regulation medium in the flow channels isolated from each other can exchange heat through the heat exchanger. That is to say, in the same regulation system, either the cooling flow channels can communicate with each other, or if there are flow channels isolated from each other, heat is exchanged through a heat exchanger.

It should be explained that, in two flow channels isolated from each other, the temperature regulation medium in any one of the flow channels will not flow to the other flow channel isolated from it.

It should be explained that a heat exchanger is a structure that can be used to perform heat exchange between different flow channels that are isolated from each other.

Exemplarily, temperature and pressure sensors are provided on the cooling flow channels of both the charging converter 3 and the charging connector 4.

Exemplarily, when the ambient temperature is about 45°C, the maximum allowable temperature of the temperature regulation medium of the charging converter 3 is about 63°C to 65°C.

Exemplarily, when the ambient temperature is about 45°C, the maximum allowable temperature of the temperature regulation medium of the charging connector 4 is about 85°C.

In the solutions of the embodiments of the present disclosure, the cooling flow channels of the charging converter 3 and the cooling flow channels of the charging connector 4 are both arranged in the cooling system 5, so that the cooling flow channels of the charging converter 3 and the cooling flow channels of the charging connector 4 are in the same cooling system, and the first heat dissipation apparatus 6 corresponding to the cooling system 5 is arranged in the first cooling system, and the first heat dissipation apparatus 6 is cooled by a fan 61 to cool the charging converter 3 and the charging connector 4. In the process of charging the electrical device through the charging connector 4, since the cooling flow channels of the charging converter 3 and the cooling flow channels of the charging connector 4 are in the same cooling system, the first heat dissipation apparatus 6 corresponding to the cooling system 5 can be fully utilized to dissipate heat from both the charging converter 3 and the charging connector 4. Furthermore, in actual application scenarios, the temperature requirements on the temperature regulation medium for the charging converter 3 and the charging connector 4 are slightly different but relatively close. Therefore, in the same cooling system, the first heat dissipation apparatus 6 and the cooling system 5 can well dissipate heat for the two relatively close temperature requirements on the temperature regulation medium.

Exemplarily, the number of the first heat dissipation apparatus 6 is one.

In an embodiment, referring to FIG. 1, the energy storage device further comprises a first circulation pump 7, and the cooling system 5 comprises a first circulation loop 50 and a cooling sub-system 51. Both the first circulation pump 7 and the cooling flow channels of the charging converter 3 are connected in series in the first circulation loop 50. The cooling sub-system 51 comprises a first pipeline 510, the first pipeline 510 is connected in series with the first circulation pump 7, and the first pipeline 510 is connected in parallel with the cooling flow channels of the charging converter 3. The first heat dissipation apparatus 6 is arranged in at least one of the first circulation loop 50 and the cooling sub-system 51 to cool the charging connector 4 and the charging converter 3.

Exemplarily, the first circulation pump 7 is an electronic pump.

In the solutions of the embodiments of the present disclosure, the energy storage device further comprises a first circulation pump 7, the cooling system 5 comprises a first circulation loop 50 and a cooling sub-system 51, the cooling sub-system 51 comprises a first pipeline 510, the charging converter 3 is arranged in the first circulation loop 50, and the first heat dissipation apparatus 6 is arranged in at least one of the first circulation loop 50 and the cooling sub-system 51. The charging converter 3 and the charging connector 4 are arranged on different pipelines, which can facilitate the arrangement of the cooling system 5. The arrangement of the first circulation loop 50 and the cooling sub-system 51 can not be restricted by the relative positions of the charging converter 3 and the charging connector 4. As the arrangement of the first circulation loop 50 and the cooling sub-system 51 is completed, the first heat dissipation apparatus 6 can cool the charging connector 4 and the charging converter 3. Furthermore, since the cooling temperatures of the charging connector 4 and the charging converter 3 are different, the cooling sub-system 51 and the first circulation loop 50 can adjust the flow rates of different temperature regulation media respectively to meet different cooling requirements.

It can be understood that the embodiments of the present disclosure are not limited to the cooling system 5 comprising the first circulation loop 50 and the cooling sub-system 51, the charging converter 3 being arranged in the first circulation loop 50, and the charging connector 4 being arranged in the cooling sub-system 51. Exemplarily, the cooling flow channels of the charging connector 4 are arranged in the first pipeline 510, and the cooling flow channels of the charging converter 3 are arranged in the first circulation loop 50.

In an embodiment, referring to FIG. 1, the cooling sub-system 51 further comprises a first heat exchanger 512, a second circulation pump 513 and a second circulation loop 511, one of the heat exchange flow channels of the first heat exchanger 512 is arranged in the first pipeline 510, the cooling flow channels of the charging connector 4, the second circulation pump 513 and another heat exchange flow channel of the first heat exchanger 512 are connected in series in the second circulation loop 511, the second circulation loop 511 is isolated from the first pipeline 510, and the first heat dissipation apparatus 6 is arranged in at least one of the first circulation loop 50, the heat exchange flow channels of the first heat exchanger 512 and the second circulation loop 511.

Exemplarily, the second circulation pump 513 is an electronic pump.

The first heat exchanger 512 is a heat exchanger capable of performing heat exchange between the first pipeline 510 and the second circulation loop 511.

The second circulation loop 511 and the first pipeline 510 are isolated from each other, which means that the temperature regulation medium in the first pipeline 510 will not flow into the second circulation loop 511, and the temperature regulation medium in the second circulation loop 511 will not flow into the first pipeline 510.

Exemplarily, the two heat exchange flow channels of the first heat exchanger are isolated from each other, but can exchange heat with each other.

In the solutions of the embodiments of the present disclosure, one of the heat exchange flow channels of the first heat exchanger 512 is arranged in the first pipeline 510, another heat exchange flow channel thereof is connected in series in the second circulation loop 511, and the first pipeline 510 and the second circulation loop 511 are isolated from each other. The first circulation loop 50 and the second circulation loop 511 can be provided with different temperature regulation media according to the characteristics of the charging converter 3 and the charging connector 4 respectively, thereby increasing the adaptability of the energy storage device and providing a better user experience.

It can be understood that the embodiments of the present disclosure are not limited to the first pipeline 510 and the second circulation loop 511 being isolated from each other. Exemplarily, the second circulation loop 511 and the first pipeline 510 communicate with each other, and the charging connector 4 and the charging converter 3 are connected in parallel.

It can be understood that when the second circulation loop 511 and the first pipeline 510 communicate with each other, the cooling sub-system 51 does not need to be provided with the first heat exchanger. The first circulation loop 50 and the second circulation loop 511 can share the first circulation pump 7 to drive the flow of the temperature regulation medium, and a plurality of circulation pumps can also be provided to speed up the flow of the temperature regulation medium.

In an embodiment, the temperature regulation medium in the first circulation loop 50 is water; and the temperature regulation medium in the second circulation loop 511 is oil.

Exemplarily, the temperature regulation medium in the first circulation loop 50 may also be an aqueous ethylene glycol solution.

Exemplarily, the temperature regulation medium in the second circulation loop 511 is silicone oil.

In the solutions of the embodiments of the present disclosure, the temperature regulation medium in the first circulation loop 50 is water. The cooling capacity required by the charging converter 3 is relatively high. The specific heat capacity of water is relatively large, and it can well cool the charging converter 3 to well meet the cooling requirements of the charging converter 3. The temperature regulation medium in the second circulation loop 511 is oil, which is difficult to conduct electricity. The energy storage device needs to discharge through the charging connector 4. In the process of cooling the charging connector 4, the risk of electric shock or short circuit caused by leakage of the temperature regulation medium is alleviated, and the energy storage device is safer.

It can be understood that the embodiments of the present disclosure are not limited to the temperature regulation medium in the first circulation loop 50 being water and the temperature regulation medium in the second circulation loop 511 being oil. Exemplarily, the temperature regulation media in the first circulation loop 50 and the second circulation loop 511 are both water.

In an embodiment, referring to FIG. 1, the cooling flow channels of the first heat dissipation apparatus 6 are arranged in the first circulation loop 50, and both the first pipeline 510 and the cooling flow channels of the charging converter 3 are connected in series with the corresponding cooling flow channels of the first heat dissipation apparatus 6.

In the solutions of the embodiments of the present disclosure, both the first pipeline 510 and the cooling flow channels of the charging converter 3 are connected in series with the corresponding cooling flow channels of the first heat dissipation apparatus 6. In the process of cooling the charging connector 4, it is necessary to start the first circulation pump 7 to make the temperature regulation medium flow in the first circulation loop 50, thereby providing power for cooling the charging converter 3. The first heat dissipation apparatus 6 can cool the charging connector 4 and the charging converter 3 together.

It can be understood that the present disclosure is not limited to both the first pipeline 510 and the cooling flow channels of the charging converter 3 being connected in series with the corresponding cooling flow channels of the first heat dissipation apparatus 6. Exemplarily, the first pipeline 510 and the cooling flow channels of the charging converter 3 are isolated from the corresponding cooling flow channels of the first heat dissipation apparatus 6.

In an embodiment, referring to FIG. 1, the first heat dissipation apparatus 6 is a cooling container 60 for accommodating a temperature regulation medium, a space in the cooling container 60 for accommodating the temperature regulation medium is arranged in a cooling system 5, and a fan 61 is used to drive air to flow through the first heat dissipation apparatus 6 to dissipate heat from the first heat dissipation apparatus 6.

Exemplarily, when the first heat dissipation apparatus 6 is arranged in the first circulation loop 50, the cooling container 60 is connected in series with the first circulation loop 50, and the temperature regulation medium in the cooling container 60 is water. When the first heat dissipation apparatus 6 is arranged in the second circulation loop 511, the cooling container 60 is connected in series with the second circulation loop 511, and the temperature regulation medium in the cooling container 60 is oil.

It can be understood that the present disclosure does not limit the relationship between the cooling container 60 and the cabinet 1. The cooling container 60 can be installed inside the cabinet 1, the cooling container 60 can also be arranged outside the cabinet 1, and the temperature regulation medium can flow to the cooling container 60 through the circulation loop of the first heat dissipation apparatus 6.

In the solutions of the embodiments of the present disclosure, the first heat dissipation apparatus 6 is a cooling container 60 for accommodating a temperature regulation medium, and the fan 61 is used to blow air to the cooling container 60. In actual usage scenarios, the charging converter 3 and the charging connector 4 require the temperature of the temperature regulation medium to be higher than the ambient temperature, and the charging converter 3 and the charging connector 4 have a weaker demand for cooling capacity. The fan 61 is used to drive the air in the surrounding environment to flow through the cooling container for air-cooling the cooling container 60, which can basically meet the cooling requirements of the charging connector 4 and the charging converter 3, so that the manufacturing cost of the energy storage device is relatively low.

It can be understood that the embodiments of the present disclosure are not limited to the first heat dissipation apparatus 6 being a cooling container 60 for accommodating a temperature regulation medium. Exemplarily, the first heat dissipation apparatus 6 is a refrigerator.

In an embodiment, the cooling container 60 is located above the battery pack 2.

In the solutions of the embodiments of the present disclosure, the battery pack 2 generates a large amount of heat during operation, and the battery pack 2 has great heat dissipation requirements. The temperature regulation medium will bring the heat of the charging converter 3 and the charging connector 4 to the cooling container 60. Hot air usually floats upward. The cooling container 60 located above the battery pack 2 can alleviate the heat transfer from the cooling container 60 to the battery pack 2, thereby capable of increasing the heat dissipation capacity of the battery pack 2 to a certain extent.

It can be understood that the embodiments of the present disclosure are not limited to the cooling container 60 being located above the battery pack 2. Exemplarily, the cooling container 60 is located below the battery pack 2.

In an embodiment, the cooling container 60 is located above the fan 61.

In the solutions of the embodiments of the present disclosure, the cooling container 60 is located above the fan 61, and the fan 61 blows air upward. The generated wind acts on the cooling container 60, which can discharge the heat of the cooling container 60 upward, resulting in a good heat dissipation effect. If the cooling container 60 is placed below the fan 61 and the fan 61 blows air downward, the generated wind will carry the heat generated by the cooling container 60 downward for a distance and then move upward, thereby acting on the cooling container 60 again, resulting in a poor heat dissipation effect.

It can be understood that the embodiments of the present disclosure are not limited to the cooling container 60 being located above the fan 61. Exemplarily, the cooling container 60 is located below or on the side of the fan 61.

In an embodiment, referring to FIG. 1, the charging converter 3 is located inside the cabinet 1.

In the solutions of the embodiments of the present disclosure, the charging converter 3 is located inside the cabinet 1, which can alleviate the influence of the external environment on the charging converter 3 and makes it more convenient in the process of transferring the energy storage device.

It can be understood that the embodiments of the present disclosure are not limited to the charging converter 3 being located inside the cabinet 1. Exemplarily, the charging converter 3 is arranged outside the cabinet 1.

In an embodiment, the charging connector 4 is partially located outside the cabinet 1.

In the solutions of the embodiments of the present disclosure, the charging connector 4 is partially located outside the cabinet 1, which can facilitate the user to move the charging connector 4 to charge the electrical device.

In an embodiment, the charging converter 3 is a DC converter.

A DC converter is a converter whose input current and output current are both direct current.

In the solutions of the embodiments of the present disclosure, since current new energy vehicles and other electrical devices are mostly charged with direct current, the current parameters of the current output from the battery pack 2 can be adjusted through a DC converter, thereby capable of adapting to the parameters of the input current of many electrical devices. The energy storage device has high adaptability.

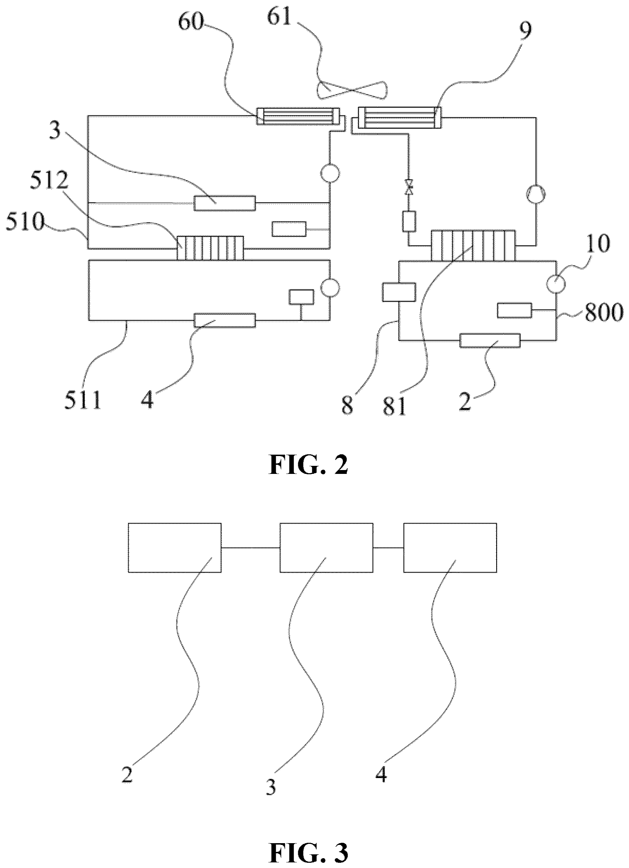

In an embodiment, referring to FIGS. 1 and 2, the energy storage device further comprises a temperature regulation system 8 and a second heat dissipation apparatus 9. The temperature regulation flow channels of the battery pack 2 are arranged in the temperature regulation system 8, and the temperature regulation system 8 is thermally separated from the cooling system 5. The second heat dissipation apparatus 9 is at least partially arranged in the temperature regulation system 8 to cool the battery pack 2.

It should be noted that the temperature regulation system 8 is a regulation system with cooling and heating functions.

The temperature regulation system 8 being thermally separated from the cooling system 5 means that the temperature regulation medium in the temperature regulation system 8 will not flow into the cooling system 5, the temperature regulation medium in the cooling system 5 will not flow into the temperature regulation system 8, and no heat exchanger will be arranged in the cooling system 5 and the temperature regulation system 8 for heat exchange.

Exemplarily, the temperature regulation flow channels of the battery pack 2 are provided with temperature and pressure sensors.

In the solutions of the embodiments of the present disclosure, the temperature requirements on the temperature regulation medium of the charging converter 3 and the charging connector 4 are different from the temperature requirements on the temperature regulation medium of the battery pack 2. The battery pack 2 uses the temperature regulation system 8 and the second heat dissipation apparatus 9 to regulate the temperature so that the energy storage device can well meet the temperature requirements of the battery pack 2 and has little effect on the cooling of the charging converter 3 and the charging connector 4.

It can be understood that the embodiments of the present disclosure do not limit the cooling mode of the battery pack 2. Exemplarily, the temperature regulation flow channels of the battery pack 2 are arranged in the cooling system 5.

In an embodiment, the second heat dissipation apparatus 9 comprises a refrigerator and a second heat exchanger 81, and the second heat exchanger 81 is arranged across the refrigerator and the temperature regulation system 8.

The second heat exchanger 81 is a heat exchanger capable of performing heat exchange between the temperature regulation system 8 and the refrigerator.

Exemplarily, the required temperature of the temperature regulation medium of the battery pack 2 is about 20°C.

In the solutions of the embodiments of the present disclosure, the second heat dissipation apparatus 9 comprises a refrigerator and a second heat exchanger 81, and the second heat exchanger 81 can perform heat exchange between the refrigerator and the temperature regulation system 8. According to the actual use environment of the battery pack 2, the required temperature of the temperature regulation medium of the battery pack 2 is lower than the ambient temperature, the cooling temperature of the battery pack 2 is relatively low, and the refrigerator can well meet the cooling requirements of the battery pack 2.

It can be understood that the embodiments of the present disclosure are not limited to the second heat dissipation apparatus 9 comprising a refrigerator. Exemplarily, the second heat dissipation apparatus 9 comprises a cooling container 60 capable of containing a temperature regulation medium.

Exemplarily, the temperature regulation system 8 comprises a third circulation loop 800 and a third circulation pump 10, and the heat dissipation flow channel corresponding to the second heat dissipation apparatus 9, the temperature regulation flow channel of the battery pack 2 and the third circulation pump 10 are connected in series in the third circulation loop 800.

In an embodiment, the refrigerator comprises a compressor, a condenser, an evaporator and an expansion valve connected end to end in sequence. The condenser dissipates heat through the fan, and when projected along the air outlet direction of the fan 61, the projection area of the condenser and the projection area of the first heat dissipation apparatus 6 are offset from each other. The second heat exchanger is arranged across the evaporator and the temperature regulation system.

A compressor is a structure that compresses and drives the refrigerant in the refrigerant circuit.

A condenser is a structure that can convert gas or vapor into liquid and transfer the heat in the pipeline to the nearby air fast.

An evaporator is a structure that uses the ability of a liquid low-temperature refrigerant to evaporate easily under low pressure and turn into steam, absorbing the heat of a medium whose temperature is to be controlled to achieve the purpose of refrigeration.

An expansion valve is a structure that allows a liquid refrigerant to throttle through it to become low-temperature, low-pressure wet steam, followed by heat absorption by the refrigerant in the evaporator to achieve a cooling effect.

The projection area of the condenser and the projection area of the first heat dissipation apparatus 6 are offset from each other, which means that there is no overlapping part between the projection area of the condenser and the projection area of the first heat dissipation apparatus 6, and the outlines of the projection areas can overlap.

In the embodiment of the present disclosure, when projected along the air outlet direction of the fan 61, the projection area of the condenser and the projection area of the first heat dissipation apparatus 6 are offset from each other. In the process of the fan 61 driving the air to flow, the heat generated by the condenser and the heat generated by the first heat dissipation apparatus 6 have little mutual influence, which can increase the heat dissipation effect of the fan 61 to a certain extent.

It can be understood that the embodiments of the present disclosure are not limited to, when projected along the air outlet direction of the fan 61, the projection area of the condenser and the projection area of the first heat dissipation apparatus 6 being offset from each other. Exemplarily, when projected along the air outlet direction of the fan 61, the projection area of the condenser at least partially overlaps with the projection area of the first heat dissipation apparatus 6.

The above are merely preferred embodiments of the present disclosure, but are not intended to limit the present disclosure. It will be apparent to those skilled in the art that various modifications and changes may be made to the present disclosure. Any modifications, equivalent replacements and improvements made within the spirit and principle of the present disclosure shall be included within the scope of protection of the present disclosure.

## Claims

1. An energy storage device, comprising:
a cabinet;
a battery pack, installed inside the cabinet;
a charging converter, electrically connected to the battery pack and used for converting electric energy outputted from or inputted to the battery pack;
a charging connector, electrically connected to the charging converter to transmit electric energy converted by the charging converter;
a cooling system, used for heat exchange with the charging converter and the charging connector;
a first heat dissipation apparatus, arranged in the cooling system;
at least one fan, installed in the cabinet and used to dissipate heat from the first heat dissipation apparatus.

2. The energy storage device according to claim 1, wherein the energy storage device further comprises a first circulation pump, and the cooling system comprises:
a first circulation loop, wherein both the first circulation pump and the cooling flow channels of the charging converter are connected in series in the first circulation loop;
a cooling sub-system, wherein the cooling flow channels of the charging connector are arranged in the cooling sub-system, the cooling sub-system comprises a first pipeline, the first pipeline is connected in series with the first circulation pump, the first pipeline is connected in parallel with the cooling flow channels of the charging converter, and the first heat dissipation apparatus is arranged in at least one of the first circulation loop and the cooling sub-system to cool the charging connector and the charging converter.

3. The energy storage device according to claim 2, wherein the cooling sub-system further comprises:
a first heat exchanger, wherein one of the heat exchange flow channels of the first heat exchanger is arranged in the first pipeline;
a second circulation pump;
a second circulation loop, wherein the cooling flow channels of the charging connector, the second circulation pump and another heat exchange flow channel of the first heat exchanger are connected in series in the second circulation loop, the second circulation loop and the first pipeline are isolated from each other, and the first heat dissipation apparatus is arranged in at least one of the first circulation loop, the heat exchange flow channels of the first heat exchanger and the second circulation loop.

4. The energy storage device according to claim 3, wherein the temperature regulation medium in the first circulation loop is water; and the temperature regulation medium in the second circulation loop is oil.

5. The energy storage device according to any one of claims 2 to 4, wherein the cooling flow channels of the first heat dissipation apparatus are arranged in the first circulation loop, and the first pipeline and the cooling flow channels of the charging converter are both connected in series with the corresponding cooling flow channels of the first heat dissipation apparatus.

6. The energy storage device according to any one of claims 1 to 5, wherein the first heat dissipation apparatus is a cooling container for accommodating a temperature regulation medium, a space in the cooling container for accommodating the temperature regulation medium is arranged in the cooling system, and the fan is used to drive air to flow through the first heat dissipation apparatus to dissipate heat from the first heat dissipation apparatus.

7. The energy storage device according to claim 6, wherein the cooling container is located above the battery pack.

8. The energy storage device according to claim 6 or 7, wherein the cooling container is located above the fan.

9. The energy storage device according to any one of claims 1 to 8, wherein the charging converter is a DC converter.

10. The energy storage device according to any one of claims 1 to 9, wherein the charging converter is located inside the cabinet.
